# EUROPÄISCHE PATENTSCHRIFT

(11) **EP 1 789 226 B1**
(45) Veröffentlichungstag und Bekanntmachung des Hinweises auf die Patenterteilung: **10.09.2014**
(21) Anmeldenummer: 05758799.0
(22) Anmeldetag: 14.07.2005
(51) Int. Cl.: B23K 20/10

(54) **ULTRASCHALLTRANSDUCER MIT EINEM IN DER LAGERUNG ANGEORDNETEN SENSOR**
ULTRASONIC TRANSDUCER COMPRISING A SENSOR ARRANGED IN THE MOUNTING
TRANSDUCTEUR A ULTRASONS COMPRENANT UN DETECTEUR DISPOSE SUR UN SUPPORT

(30) Priorität: 17.09.2004 DE 102004045575
(43) Veröffentlichungstag der Anmeldung: 30.05.2007
(73) Patentinhaber: Hesse GmbH, 33100 Paderborn (DE)
(72) Erfinder: HESSE, Hans-Jürgen, 33106 Paderborn (DE); WALLASCHEK, Jörg, 33106 Paderborn (DE); Herr Prof.Dr. VASILJEV, Piotr c/o Hesse & Knipps GmbH, 33100 Paderborn (DE)
(74) Vertreter: Wickord, Wiro
(86) Internationale Anmeldenummer: PCT/EP2005/007691
(87) Internationale Veröffentlichungsnummer: WO 2006/032316

(56) Entgegenhaltungen:
- EP-A- 0 761 371
- US-A- 5 607 096
- US-B1- 6 279 810
- US-B1- 6 286 747

## Beschreibung

Die Erfindung betrifft einen Ultraschalltransducer nach dem Oberbegriff des Patentanspruchs 1 um ein Verfahren zur messtechnischen Erfassung zumindest einer Messgröße, die Rückschlüsse auf einen Prozessparameter bzw. Prozessgrößen bei einer Ultraschallanwendung zulässt gemäß Anspruch 14.

Ultraschalltransducer, insbesondere wie sie bei Bondmaschinen zum Einsatz kommen, umfassen als wesentliche Elemente wenigstens einen Ultraschall-Schwingungserzeuger (z.B. aus Piezo-Elementen), ein Horn und ein Werkzeug, welches über das Horn mit dem Schwingungserzeuger verbunden ist.

Es ist im Stand der Technik bekannt, an einem Horn eines Ultraschalltransducers Sensoren vorzusehen, um Prozessparameter, z.B. die momentane Ultraschallleistung oder die aufgebrachte Kraft zu kontrollieren, oder bei einem Bondvorgang zu überwachen und gegebenenfalls nachzuregeln und so insbesondere bei Bondmaschinen eine Qualitätssicherung zu betreiben.

Ein Ultraschalltransducer mit Sensorelementen am Horn ist beispielsweise aus der EP 0 275 877 bekannt. Dieses Dokument zeigt einen Ultraschalltransducer mit einem Horn, welches Abflachungen, Ausfräsungen oder sonstige Ausnehmungen zeigt, in denen Sensoren angeordnet werden können. So ist in dem Dokument die Anordnung von Dehnungsmessstreifen in einer oberen und unteren Abflachung des Hornes beschrieben, um die vertikale Verbiegung des Hornes während eines Bondvorgangs zu messen und aus dieser Größe die wirkende Bondkraft zu bestimmen.

Die bekannte Anordnung weist die Nachteile auf, dass die Ultraschalltransducer bzw. hier das Horn speziell für die Anbringung von Sensoren vorbereitet werden müssen, beispielsweise durch die genannten Ausfräsungen, Abflachungen oder sonstige Materialabtragungen. Derartige Materialabtragungen nehmen letztendlich Einfluss auf die Stabilität des gesamten Ultraschalltransducers, sind aufwendig in der Herstellung und bedingen je nach Einsatzgebiet speziell angepasste Ultraschalltransducer. Darüber hinaus gehören bei den bekannten Anordnungen die Sensoren selbst mit zum schwingenden System, was letztendlich die Abstimmung des Schwingungssystems an sich erschwert.

Darüber hinaus ist als Nachteil festzuhalten, dass bestehende Ultraschallsysteme bzw. -transducer nicht in der bekannten Art und Weise mit Sensoren ausgerüstet werden können, um Prozessparameter zu überwachen.

Ein Ultraschalltransducer mit zugeordnetem Sensor ist beispielsweise aus der EP 0 761 371 A1 bekannt. Der Ultraschalltransducer wird in eine Haltevorrichtung vorgesehen, wobei an der Haltevorrichtung ein Sensor vorgesehen ist zur Detektion einer definierten Festlegung des Ultraschalltransducers an der Haltevorrichtung.

Weiter sind aus der US 5 607 096 A, der US 6 279 810 B1 und der US 6 286 747 B1 Ultraschalltransducer mit applizierten Sensoren bekannt, welche auf verschiedene Weise die Detektion einer Bondkraft oder anderer charakteristischer Parameter des Bondprozesses erlauben. Bekannt ist hierbei, den Sensor unmittelbar an einen Piezo-Stapel oder im Kraftfluss des Ultraschalltransducers vorzusehen. Jeweils ist der Aufbau vergleichsweise komplex, und eine Nachrüstung bei bestehenden Systemen nicht in einfacher Weise möglich.

Weiter ist aus der JP 0 206 15 67 A ein Durchführungsisolator bekannt.

Aufgabe der Erfindung ist es, einen Ultraschalltransducer mit wenigstens einem Sensor bereit zu stellen, mittels dem eine Überwachung möglicher interessierender Prozessparameter auf konstruktiv einfache Art und Weise möglich ist, wobei insbesondere eine wesentliche Einflussnahme durch den Sensor auf ein abgestimmtes schwingendes System vermieden wird. Weiterhin ist es Aufgabe der Erfindung, eine Möglichkeit bereit zu stellen, mittels der bestehende Ultraschalltransducer bzw. Ultraschalltransducersysteme nachgerüstet werden können, um die Überwachung interessierender Prozessparameter zu erreichen.

Diese Aufgabe wird durch einen Ultraschalltransducer mit den Merkmalen des Patentanspruchs 1 gelöst. Das erfindungsgemäße Verfahren weist die Merkmale des Patentanspruchs 14 auf.

Die erfindungsgemäße Anordnung eines oder mehrerer Sensoren in bzw. an der Lagerung eines Ultraschalltransducers hat den besonderen Vorteil, dass der Ultraschalltransducer und insbesondere ein Ultraschalltransducer dieser erfindungsgemäßen Art keine besondere Konstruktion aufweisen müssen, um mit Sensoren ausgestattet zu werden. So entfallen bei der Anbringung von Sensoren in bzw. an der Lagerung sämtliche konstruktiven Maßnahmen, um Ausfräsungen, Abflachungen oder andere Materialabtragungen der vorbekannten Art, insbesondere am Horn durchzuführen.

Dabei wird im Rahmen der Erfindung die Lagerung des Ultraschalltransducers als sich senkrecht zur Längsachse des Ultraschalltransducers erstreckende, insbesondere ringförmige Membran ausgebildet, wobei es erfindungsgemäß vorgesehen ist, an bzw. in der Membran wenigstens einen Sensor anzuordnen.

Eine derartige Membran bildet eine konstruktiv einfache und vorteilhafte Anbindung eines Ultraschalltransducer an eine umgebende Vorrichtung, weist aufgrund ihrer geringen Dicke gegenüber der radialen Ausbreitung eine sehr geringe Masse und darüber hinaus hervorragende Eigenschaften auf, um eine Querdehnung oder eine sonstige Verformung in der großflächigen Membran mit hoher Empfindlichkeit messtechnisch zu erfassen.

Es besteht auf diese Art und Weise auch die Möglichkeit, bestehende Ultraschalltransducer mit Sensoren nachzurüsten, da durch die Anbringung der Sensoren in bzw. an der Lagerung des Ultraschalltransducers das eigentliche Horn, bzw. der gesamte Ultraschalltransducer ungeändert bleiben kann und so kein wesentlicher Einfluss auf die Abstimmung des Gesamtsystems vorgenommen wird.

Die Längsschwingung ist im Ultraschalltransducer mit der Querdehnung gekoppelt (über die Querkontraktion), so dass bei einer Messung der Querschwingung bzw. eines die Querschwingung oder die Querdehnung repräsentierenden Messwertes auf die Längsschwingung geschlossen werden kann.

Unter der Lagerung eines Ultraschalltransducers wird im Sinne der Erfindung die Einrichtung verstanden, mittels der ein Ultraschalltransducer an einer anderen Vorrichtung befestigt ist, wie beispielsweise an dem Bondkopf einer Bondmaschine. Hierbei kann eine Lagerung des Ultraschalltransducers z.B. am/im Horn oder z.B. an bzw. im Schwingungserzeuger (z.B. Piezoelemente) vorgesehen sein.

Eine solche Lagerung kann bevorzugt im Knotenpunkt der sich ausbreitenden angeregten longitudinalen Ultraschallwelle angeordnet werden, so dass an dieser Stelle aufgrund des Knotens bei der Longitudinalwelle eine hohe Querdehnung, bzw. ein Maximum der Querdehnung im Ultraschalltransducer, z.B. im Horn, vorliegt, wobei weiterhin besonders bevorzugt mit einem in bzw. an der Lagerung angeordneten Sensor die Querdehnung an einer Stelle des Ultraschalltransducers senkrecht zur sich ausbreitenden angeregten Ultraschallwelle messtechnisch erfassbar ist. Da an einem Knotenpunkt der Longitudinalwelle das Maximum der Longitudinaldehnung vorliegt, ergibt sich an dieser Stelle auch das Maximum der Querdehnung.

Hierbei kann die Lagerung des Ultraschalltransducers z.B. Teil des Hornes sein, insbesondere kann sich das Horn beidseitig der Lagerung erstrecken bzw. durch die Lagerung hindurchführen. Ebenso kann die Lagerung z.B. Teil des Ultraschallerzeugers bzw. in diesem angeordnet sein. So kann der Ultraschallerzeuger sich z.B. zu beiden Seiten der Lagerung erstrecken, z.B. dadurch, dass vor und hinter der Lagerung schwingungserzeugende Elemente angeordnet sind, wie z.B. Piezoelemente. Die schwingungserzeugenden Elemente konnten z.B. derart (beispielsweise symmetrisch) angeordnet sein, dass sich in der Lagerung ein Schwingungsknoten der longitudinalen Ultraschallwelle ergibt.

Aus der messtechnischen Erfassung von Messgrößen (wenigstens einer Messgröße) mittels wenigstens eines Sensors in bzw. an der Lagerung des Ultraschalltransducers, wie beispielsweise einer eine Querdehnung repräsentierenden Messgröße in einem der Elemente des Ultraschalltransducers eröffnet sich die Möglichkeit, Prozessparameter während eines Bondvorgangs auszuwerten, z.B. zur Qualitätsbeurteilung des Bondprozesses und/oder als Regelgröße z.B. zur Nachregelung einer Bondkraft, Ultraschallleistung oder Ultraschallfrequenz einzusetzen.

In einer bevorzugten Ausführung kann vorgesehen sein, dass wenigstens auf der einen Seite der Membran wenigstens ein Sensor angeordnet ist. Dementsprechend kann es ebenso vorgesehen sein, beidseitig der Membran wenigstens einen Sensor anzuordnen.

Die Anordnung eines Sensors auf der Membran kann durch jede Art der Befestigung erreicht werden, wobei besonders bevorzugt ein Sensor auf die Membran aufgeklebt werden kann. Gerade auch hierdurch ergibt sich die Möglichkeit, bestehende Ultraschalltransducer nachträglich mit Sensoren zur Überwachung von Prozessparametern auszustatten, ohne hierbei signifikanten Einfluss auf ein abgestimmtes Ultraschallsystem zu nehmen.

Ebenso kann ein Sensor z.B. auf/an die Membran geschraubt werden, z.B. mittels eines laschenförmigen Elementes, welches unter einem Winkel fähnchenartig von der Membran absteht, bevorzugt unter 90 und besonders bevorzugt unter 45 Grad.

In einer bevorzugten und einfachen Ausführungsform kann ein Sensor beispielsweise als piezoelektrischer Sensor, einfacherweise als ein piezoelektrisches Element ausgebildet sein. Dies hat den Vorteil, dass durch eine einwirkende Dehnung bzw. Verformung auf einem Sensor eine elektrische Spannung am Sensor erzeugt wird, die auf besonders einfache Art und Weise messtechnisch erfasst werden kann.

Dies kann z.B. bei Piezoelementen durch Dehnung oder Verformung gegeben sein , insbesondere aufgrund der in einer bestimmten Vorzugsrichtung gegebenen polaren Achse eines piezoelektrischen Elementes.

Hierbei kann es grundsätzlich vorgesehen sein, dass die polare Achse eines piezoelektrischen Elementes je nach Anwendungsfall sowohl senkrecht als auch gegebenenfalls parallel zur Ebene der Membran ausgerichtet ist.

Ebenso ergeben sich unterschiedliche Möglichkeiten, Spannungswerte an piezoelektrischen Sensoren/Elementen abzugreifen. So kann beispielsweise eine der Flächen eines piezoelektrischen Elementes bzw. Sensors, zwischen denen eine Spannung bei Druck-, Zug- oder Scherbeanspruchung erzeugbar ist, in direktem Kontakt mit der Lagerung und insbesondere der Membran einer Lagerung stehen. Beispielsweise kann auf diese Weise eine derartige Fläche mit dem Massepotential einer Vorrichtung, beispielsweise einer Bondmaschine, verbunden sein. Die Membran selbst kann so eine Elektrode eines piezoelektrischen Elementes bilden.

Spannungen, die sich dementsprechend bei einer Beanspruchung des Piezoelementes ergeben, können von einer der Piezoflächen durch Abgriff an einer Elektrode des Piezoelementes bezogen auf das Massepotential ermittelt und messtechnisch weiter verarbeitet werden.

Ebenso ist es möglich, Spannungen zwischen zwei gegen die Umgebung isolierte Elektroden ein- und desselben Piezoelementes zu erfassen oder auch Spannungen zwischen mehreren, an der Lagerung vorgesehenen Piezosensoren, insbesondere mehreren Piezoelementen zu messen. Hierbei können insbesondere unterschiedlich konfigurierte Piezoelemente eingesetzt werden, beispielsweise welche, die einen piezoelektrischen Effekt aufgrund einer Druck bzw. Zugbewegung oder einer Schub- oder Scherbewegung aufweisen.

In einer besonders bevorzugten Ausführung kann es auch vorgesehen sein, dass ein Sensor wenigstens ein piezoelektrisches Element oder mehrere piezoelektrische Elemente umfasst, insbesondere das bzw. die den Ultraschalltransducer und hier insbesondere das Horn bzw. allgemein die Längsachse ringförmig umgeben. So kann die Membran einer Lagerung z.B. in mehrere Teilbereiche aufgeteilt sein, wobei jeder dieser Teilbereiche, die beispielsweise den Ultraschalltransducer umgeben, ein piezoelektrisches Element mit einer oder mehreren Elektroden zum Spannungsabgriff aufweisen kann.

Ebenso kann ein einziges piezoelektrisches Element ringförmig ausgestaltet sein, wobei ein derartiges piezoelektrisches Element die Längsachse und insbesondere das Horn umgebend an der Membran befestigt sein kann.

Vorteilhafte Ausgestaltungen eines solchen ringförmigen Piezoelementes können mehrere, wenigstens zwei ringförmige koaxial zueinander angeordnete Elektroden aufweisen, wobei auch hier eine Elektrode durch die Membran selbst gebildet sein kann. Sodann ist es möglich, Spannungsabgriffe zwischen verschiedenen Ringelektroden durchzuführen und hierbei auf die vorherrschenden Dehnungen, insbesondere Querdehnungen, oder Verformungen z.B. im Ultraschalltransducer bzw. in der Lagerung und insbesondere in der Membran zurückzuschließen. Durch die Anordnung mehrerer Abgriffelektroden auf dem Piezoelement der Membran, wobei die einzelnenen Elektroden als Teilkreis mit einem bestimmten Öffnungswinkel (z.B. 2π/Anzahl der Elektroden) ausgeführt werden, können parasitäre Schwingungen erfaßt werden, z.B. Drehschwingungen, Querschwingungen etc.

Bei einer bevorzugten Ausgestaltung eines Sensors mit einem Piezoelement und einer Vielzahl von insbesondere ringförmigen Elektroden ist die Möglichkeit gegeben, Potentialdifferenzen zwischen jeweils zwei Elektroden abzugreifen, wobei je nach Auswahl der Elektroden die Richtung, in der eine Dehnung oder Verformung erfasst werden soll, variieren kann. So besteht die Möglichkeit, mit einem erfindungsgemäßen Ultraschalltransducer, der mehrere insbesondere ringförmige Elektroden an einem oder mehreren Piezoelementen in seiner Lagerung umfasst, gleichzeitig verschiedene Potentiale zu messen und aufgrund von Potentialdifferenzen zwischen bestimmten Elektroden oder Piezoelementen auf die Größe einer Dehnung in einer ausgewählten Richtung, die z.B. der Richtung entspricht, in der die ausgewählten Elektroden/Piezoelemente liegen, zu schließen.

Der Stand der Technik sowie Ausführungsbeispiele der Erfindung sind in den nachfolgenden Figuren dargestellt. Es zeigen:
- Figur 1:: einen Ultraschalltransducer gemäß EP 0 275 877
- Figur 2a - d:: Anordnungen einer oder mehrerer Elektroden an einem Piezoelement auf der Membran einer Transducerlagerung
- Figur 3:: einen Querschnitt durch eine erfindungsgemäße Anordnung nach Figur 2
- Figur 4:: Anordnung eines laschenartigen Sensors an der Membran des Transducers.

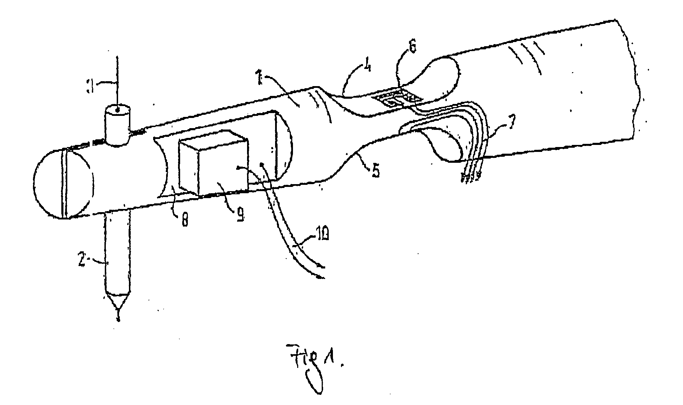

Figur 1 zeigt einen im Stand der Technik gemäß der EP 0 275 877 bekannten Ultraschalltransducer 1, der mehrere Ausfräsungen bzw. Materialausnehmungen 4,5, 8 aufweist, in denen Sensoren 6 bzw. 9 angeordnet sind. Hier wird deutlich, dass es zur Anordnung der Sensoren 6,9 gemäß dem bekannten Ultraschalltransducer einer intensiven konstruktiven Bearbeitung des Hornes 1 bedarf, beispielsweise um die gesamte schwingende Masse exakt abzustimmen. Ebenso ist erkennbar, dass durch die Ausfräsungen 4 und 5 die Biegesteifigkeit des Hornes 1 leidet, was im hier bekannten Anwendungsfall eingesetzt wird, um gerade die beim Bonden entstehende Verbiegung des Hornes zu erfassen und hieraus die Bondkraft abzuleiten.

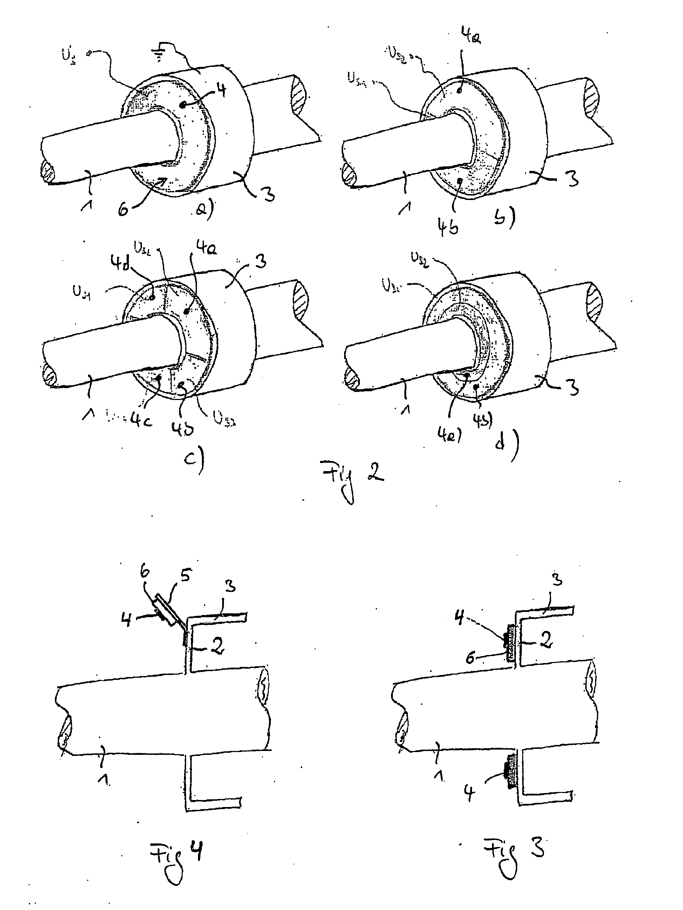

Demgegenüber zeigen die Figuren 2,3 und 4 in unterschiedlichen Darstellungen mehrere mögliche Ausführungsformen gemäß der Erfindung. Dargestellt ist jeweils in den Figuren 2a - d sowie der Figur 3 das Horn 1 eines Ultraschalltransducers , mit einer Lagerung 2,3 zur Befestigung eines solchen Horns 1 an einer weiteren Vorrichtung, wie beispielsweise dem hier nicht gezeigten Bondkopf einer Bondmaschine. Hierbei kann die Lagerung einen Teil des Hornes bilden, z.B. mit diesem einstückig ausgebildet sein. Auch kann die Lagerung als separates Teil mit einem Horn oder mit jedem anderen Teil bzw. Element eines Ultraschalltransducers, wie beispielsweise dem Schwingungserzeuger verbunden sein.

Die Lagerung ist bevorzugt im Knotenpunkt der Longitudinalschwingung angeordnet und umfasst im vorliegenden Ausführungsbeispiel im Wesentlichen eine dünne Membran 2, die sich senkrecht zur Längsachse des Ultraschalltransducers bzw. des Hornes 1 erstreckt und in einen wiederum hierzu senkrecht verlaufenden, sich koaxial um das Horn 1 erstreckenden Montagering 3 übergeht. Mittels dieses Montagerings 3 kann beispielsweise der Ultraschalltransducer 1 der hier dargestellten erfindungsgemäßen Art klemmend an einer anderen Vorrichtung, beispielsweise einer Bondmaschine, befestigt werden.

Aufgrund der Anordnung der Membran 2 als Lagerung in einem Knotenpunkt der Longitudinalwelle werden in der auf der Längsachse des Transducers senkrecht stehenden Ebene in der Lagerung und damit bevorzugt in der Membran 2 hohe Querdehnungen erreicht, so dass es sich gemäß der Erfindung empfiehlt, über diese Membran 2 durch Anordnung wenigstens eines Sensors an bzw. in dieser Membran die Querdehnungen oder auch sonstige Verformungen der Membran 2 aufzunehmen.

Dehnungen und/oder Verformungen der Membran 2 jeglicher Art und bevorzugt in jeder gewünschten Richtung können, wie in dem hier dargestellten Anwendungsfall gemäß den Figuren 2a - d durch ein Piezoelement 6 mit Elektroden 4 erreicht werden, welches bei den vorliegenden Ausführungen auf die eine außerhalb des Montagerings 3 liegende Oberfläche der Membran 2 aufgebracht ist, beispielsweise durch Verklebung. Dies zeigt im Wesentlichen besonders gut die Schnittdarstellung gemäß der Figur 3.

In der Ausführung gemäß der Figur 2a ist auf die Oberfläche der Membran 2 ein ringförmig, das Horn 1 umgebendes piezoelektrisches Element 6 aufgeklebt, wobei in dieser Ausführung die sichtbare Oberfläche des Piezoelementes 6 eine Elektrode 4 aufweist und die auf die Membran 2 aufgeklebte Fläche des Piezoelementes 6 die andere, in diesem Fall geerdete Elektrode bildet. Die Erdung wird hier vorzugsweise dadurch erreicht, dass ein elektrisch leitfähiger Kleber verwendet wird und die Vorrichtung zur Halterung des Hornes 1, wie beispielsweise eine Bondmaschine, an sich und ihren metallischen Teilen geerdet ist.

Sodann kann zwischen der hier sichtbaren Oberfläche des piezoelektrischen Elementes 6 und der Masse eine Spannung U_{S} abgegriffen werden, die nach den piezoelektrischen Materialeigenschaften und der Ausrichtung der polaren Achse eine Dehnung oder Verformung der Membran 2 und damit des Piezoelementes 6 in einer vorgegebenen Richtung repräsentiert. Dementsprechend kann aus der Spannungsmessgröße U_{S} auf einen Prozessparameter zurückgeschlossen werden.

Die Figur 2b zeigt demgegenüber eine Ausführung, bei der auf einem ringförmigen Piezoelement 6 zwei halbringartige Elektrodenelemente 4a und 4b einander gegenüberliegend ringförmig das Horn 1 umgeben. Bei dieser Ausführung kann beispielsweise jeweils eine Spannung U_{S1} und U_{S2} bezüglich des Massepotentials der Membran abgegriffen werden, so dass auch Spannungsdifferenzen zwischen den beiden Elektrodenelementen 4a und 4b messtechnisch erfassbar sind. Auch hierdurch können Dehnungen und Verformungen, insbesondere Dehnungen in der Richtung der Hochachse, vermessen werden.

Die Figur 2c zeigt eine Anordnung, bei der insgesamt vier Elektroden 4a, b, c und d ringförmig auf einem ringförmigen Piezoelement das Horn 1 umgebend auf der Membran 2 angeordnet sind. Letztendlich kann dementsprechend das ringförmige Piezoelement 6 in vier Quadranten aufgeteilt werden, um so in einer Verbindungsrichtung zweier gegenüber oder nebeneinander liegender Quadranten eine Spannungsdifferenz zu ermitteln und hieraus auf Dehnungen oder Verformungen der Membran in dieser ausgezeichneten Richtung zu schließen. Auf diese Weise lassen sich parasitäre Schwingungen, wie z.B. Torsionschwingungn, Nickschwingungen und Querschwingungen gleichermaßen erkennen.

Die Figur 2d zeigt eine alternative Anordnung, bei der zwei ringförmig ausgebildete Elektroden 4a und 4b einander koaxial umgebend auf der Oberfläche eines ringförmigen Piezoelementes 6 angeordnet sind, welches an der Membran 2 befestigt ist. Auch hierbei können Spannungsdifferenzen zwischen den beiden Ringelektroden4a und 4b messtechnisch erfasst werden und so auf eine bestimmte in der Membran gegebene Verformung oder Dehnung geschlossen werden.

Die vorgenannten speziellen gezeigten Ausführungen lassen sich beliebig erweitern durch andersartige Anordnung der Elektroden 4 auf der Oberfläche eines oder mehrerer an/auf der Membran 2 befestigten Piezoelemente/s. Ebenso ist es, wie hier nicht dargestellt, möglich, auf der inneren und äußeren Oberfläche einander gegenüberliegende Piezoelemente anzuordnen und ebenso Spannungsdifferenzen zwischen diesen Elementen zu messen.

In einer anderen Ausführung gemäß der Figur 4 ist ein laschenartiges Element 5 auf der Oberfläche der Membran 2 derart, z.B. durch Verschraubung befestigt, dass dieses Element etwa fähnchenartig unter 45 Grad von der Oberfläche der Membran 2 absteht. Dieses Element 5 träg ein Piezoelement 6, welches an seiner äußeren Oberfläche eine Elektrode 4 aufweist, mittels der eine Spannung zwischen dieser Elektrode 4 und der eine weitere Elektrode bildenden Rückseite des Piezoelementes 6 meßbar ist. Hierzu ist bevorzugt das laschenförmige Trägerelement metallisch ausgebildet und auf diese Art geerdet.

Ebenso ist es möglich, mehrere laschenförmige Elemente vorzusehen mittels denen wie in der zuvor beschriebenene Ausführung richtungsabhängige parasitäte Schwingungen erfassbar sind.

Aufgrund der Anordnung wird bei auftretenden Querschwingungen das laschenförmige Element zu Schwingungen angeregt, die abgreifbare Spannungen im Piezoelement erzeugen.

Insgesamt zeigt sich, dass durch die üblicherweise bei Ultraschalltransducern vorgesehene Lagerung zur Befestigung dieser Transducer an anderen

Vorrichtungen eine hervorragende Möglichkeit gegeben ist, Sensoren, insbesondere piezoelektrische Sensoren, vorzusehen, um eine Messgröße zu erfassen, die auf einen Prozessparameter bzw. Prozeßgrößen bei einer Ultraschallanwendung Rückschlüsse zulässt.

So kann beispielsweise auf die Ultraschallleistung, die aktuell über den Transducer übertragen wird oder auch auf eventuelle wirkende Kräfte in der Spitze eines Ultraschallwerkzeuges zurückgeschlossen werden. Auch die Messung von Kräften, insbesondere Bondkräften, ist mit dieser erfindungsgemäßen Vorrichtung auf besonders einfache Weise möglich, da die Einwirkung von Kräften an der Spitze des am Transducer angeordneten Werkzeugs die Bewegung des Hornes und damit die Dehnung und/oder Verformung in der großflächigen Membran 2 beeinflußt und sich in einer signifikanten Veränderung der elektrischen Messgröße niederschlagen kann.

Besonders deutlich wird in den dargestellten Ausführungsformen, dass bestehende Ultraschalltransducer nachträglich durch Sensoren ergänzt werden können, um Prozessparameter bzw. Prozeßgrößen messtechnisch erfassen zu können. Eine Veränderung der Geometrie des Ultraschalltransducer ist gemäß der Erfindung nicht nötig.

## Patentansprüche

1. Ultraschalltransducer mit wenigstens einem Sensor, insbesondere zum Einsatz bei Ultraschallbondern, wobei wenigstens ein Sensor (4, 6) in/an einer Lagerung (2, 3) zur Befestigung des Ultraschalltransducers an einen Bondkopf einer Bondmaschine angeordnet ist, mittels dem eine Querdehnung senkrecht zu einer sich ausbreitenden anregenden Ultraschallwelle messtechnisch erfassbar ist, **dadurch gekennzeichnet, dass** die Lagerung (2, 3) zur Befestigung des Ultraschalltransducers an einen Bondkopf einer Bondmaschine eine sich senkrecht zur Längsachse des Ultraschalltransducers erstreckende Membran (2) umfasst und an/in der Membran (2) wenigstens ein Sensor (4, 6) angeordnet ist.'

2. Ultraschalltransducer nach Anspruch 1, **dadurch gekennzeichnet, dass** die Membran (2) als eine ringförmige Membran (2) ausgebildet ist.

3. Ultraschalltransducer nach einem der vorherigen Ansprüche, **dadurch gekennzeichnet, dass** wenigstens einseitig der Membran (2) wenigstens ein Sensor (4, 6) angeordnet ist.

4. Ultraschalltransducer nach einem der vorherigen Ansprüche, **dadurch gekennzeichnet, dass** ein Sensor (4, 6) auf die Membran (2) aufgeklebt und/oder angeschraubt ist, insbesondere als ein von der Membran abstehendes laschenförmiges Element 5.

5. Ultraschalltransducer nach einem der vorherigen Ansprüche, **dadurch gekennzeichnet, dass** ein Sensor (4, 6) als piezoelektrischer Sensor ausgebildet ist.

6. Ultraschalltransducer nach Anspruch 5, **dadurch gekennzeichnet, dass** ein Sensor (4, 6) wenigstens ein piezoelektrisches Element (6) umfasst, insbesondere welches die Längsachse des Ultraschalltransducer ringförmig umgibt/umgeben.

7. Ultraschalltransducer nach einem der vorherigen Ansprüche, **dadurch gekennzeichnet, dass** ein piezoelektrisches Element (6) wenigstens zwei Elektroden (4a, 4b, 4c, 4d) aufweist, zwischen denen eine Potenzialdifferenz messbar ist, insbesondere wobei die Elektroden koaxial zueinander angeordnet sind.

8. Ultraschalltransducer nach einem der vorherigen Ansprüche, **dadurch gekennzeichnet, dass** wenigstens ein von der Querdehnung abhängiger Messwert (Uₛ) durch Messung einer Potentialdifferenz
- zwischen den Elektroden (4a, 4b, 4c, 4d) zweier piezoelektrischer Elemente (6) oder
- zwischen zwei auf einem piezoelektrischen Element (6) beabstandet angeordneten Elektroden (4a, 4b, 4c, 4d) oder zwischen mehreren beabstandet angeordneten Elektroden gegen eine gemeinsame Elektrode, insbesondere Masse erfassbar ist, insbesondere wobei die Membran selbst eine Elektrode bildet.

9. Ultraschalltransducer nach einem der vorherigen Ansprüche, **dadurch gekennzeichnet, dass** an der Membran (2) wenigstens ein laschenförmiges Element (5) befestigbar/befestigt ist, welches wenigstens bereichsweise ein piezoelektrisches Element (6), insbesondere mit einer Elektrode (4) trägt.

10. Ultraschalltransducer nach einem oder mehreren der vorherigen Ansprüche, **dadurch gekennzeichnet, dass** die Membran (2) eine geringe Dicke gegenüber der radialen Ausbreitung aufweist.

11. Ultraschalltransducer nach einem oder mehreren der vorherigen Ansprüche, **dadurch gekennzeichnet, dass** die Lagerung (2, 3) zur Befestigung des Ultraschalltransducers an einen Bondkopf einer Bondmaschine im Knotenpunkt der sich ausbreitenden angeregten longitudinalen Ultraschallwelle angeordnet ist.

12. Ultraschalltransducer nach einem oder mehreren der vorherigen Ansprüche, **dadurch gekennzeichnet, dass** eine Elektrode durch die Membran (2) selbst gebildet ist.

13. Ultraschalltransducer nach einem oder mehreren der vorherigen Ansprüche, **dadurch gekennzeichnet, dass** die dünne Membran (2) in einen senkrecht zu der Membran (2) verlaufenden, sich koaxial um das Horn (1) des Ultraschalltransducer erstreckenden Montagering (3) übergeht.

14. Verfahren zur messtechnischen Erfassung zumindest einer Messgröße, die Rückschlüsse auf einen Prozessparameter bzw. Prozessgrößen bei einer Ultraschallanwendung zulässt, unter Verwendung eines Ultraschalltransducers nach einem oder mehreren der vorherigen Ansprüche, insbesondere unter Erfassung einer eine Querdehnung repräsentierenden Messgröße, wobei während des Bondvorgangs Prozessparameter ausgewertet werden zur Qualitätsbeurteilung des Bondprozesses und/oder als Regelgröße, insbesondere zur Nachregelung der Bondkraft, Ultraschallleistung oder Ultraschallfrequenz, eingesetzt werden.

15. Verfahren nach Anspruch 14, **dadurch gekennzeichnet, dass** anhand der zumindest einen erfassten Messgröße auf die Ultraschallleistung, die aktuell über den Transducer übertragen wird, oder auch auf in oder an der Spitze des Ultraschallwerkzeuges wirkende Kräfte, insbesondere auf Bondkräfte, zurückgeschlossen wird.

## Claims

1. Ultrasonic transducer having at least one sensor, in particular for use in ultrasonic bonders, wherein at least one sensor (4, 6) is disposed in/on a mounting (2, 3) for attachment of the ultrasonic transducer to a bonding head of a bonding machine, by means of which a transverse expansion perpendicular to an exciting, spreading ultrasound wave can be determined by measuring technology, **characterised in that**, for attachment of the ultrasonic transducer to a bonding head of a bonding machine, the mounting (2, 3) comprises a membrane (2) extending perpendicular to the longitudinal axis of the ultrasonic transducer, and at least one sensor (4, 6) is disposed on/in the membrane (2).

2. Ultrasonic transducer as claimed in claim 1, **characterised in that** the membrane (2) is formed as an annular membrane (2).

3. Ultrasonic transducer as claimed in any one of the preceding claims, **characterised in that** at least one sensor (4, 6) is disposed at least on one side of the membrane (2).

4. Ultrasonic transducer as claimed in any one of the preceding claims, **characterised in that** a sensor (4, 6) is stuck and/or screwed to the membrane (2), in particular as a tab-like element 5 protruding from the membrane.

5. Ultrasonic transducer as claimed in any one of the preceding claims, **characterised in that** a sensor (4, 6) is formed as a piezoelectric sensor.

6. Ultrasonic transducer as claimed in claim 5, **characterised in that** a sensor (4, 6) comprises at least one piezoelectric element (6), in particular which surround(s) the longitudinal axis of the ultrasonic transducer in an annular manner.

7. Ultrasonic transducer as claimed in any one of the preceding claims, **characterised in that** a piezoelectric element (6) comprises at least two electrodes (4a, 4b, 4c, 4d), between which a potential difference can be measured, in particular wherein the electrodes are disposed coaxially with respect to one another.

8. Ultrasonic transducer as claimed in any one of the preceding claims, **characterised in that** at least one measurement value (Us) dependent upon the transverse expansion can be determined by measuring a potential difference
- between the electrodes (4a, 4b, 4c, 4d) of two piezoelectric elements (6) or
- between two electrodes (4a, 4b, 4c, 4d) disposed spaced apart on a piezoelectric element (6) or between a plurality of spaced-apart electrodes against a common electrode, particularly ground, in particular wherein the membrane itself forms an electrode.

9. Ultrasonic transducer as claimed in any one of the preceding claims, **characterised in that** at least one tab-like element (5) is/can be attached to the membrane (2) and, at least in regions, supports a piezoelectric element (6), in particular with an electrode (4).

10. Ultrasonic transducer as claimed in any one or several of the preceding claims, **characterised in that** the membrane (2) is thinner than the radial spread.

11. Ultrasonic transducer as claimed in any one or several of the preceding claims, **characterised in that**, for attachment of the ultrasonic transducer to a bonding head of a bonding machine, the mounting (2,3) is disposed in the node point of the excited, spreading longitudinal ultrasound wave.

12. Ultrasonic transducer as claimed in any one or several of the preceding claims, **characterised in that** an electrode is formed by the membrane (2) itself.

13. Ultrasonic transducer as claimed in any one or several of the preceding claims, **characterised in that** the thin membrane (2) merges into a mounting ring (3) extending perpendicular to the membrane (2) and extending coaxially around the horn (1) of the ultrasonic transducer.

14. Method for determination by measuring technology of at least one measurement variable, which permits conclusions to be drawn in relation to a processing parameter or processing variables in the case of an ultrasound application, using an ultrasonic transducer as claimed in any one or several of the preceding claims, in particular with determination of a measurement variable representing a transverse expansion, wherein, during the bonding process, processing parameters are evaluated to judge the quality of the bonding process and/or as an adjustment variable, in particular for readjustment of the bonding force, ultrasound output or ultrasound frequency.

15. Method as claimed in claim 14, **characterised in that** with the aid of the at least one determined measurement variable, conclusions are drawn about the ultrasound output currently being transmitted via the transducer, or even about forces acting in or on the tip of the ultrasonic tool, in particular about bonding force.

## Revendications

1. Transducteur à ultrasons comprenant au moins un détecteur, destiné en particulier à être utilisé dans des dispositifs d'assemblage par ultrasons, au moins un détecteur (4, 6) étant disposé dans/sur un support (2, 3) pour la fixation du transducteur à ultrasons sur une tête d'assemblage d'une machine d'assemblage, au moyen duquel un allongement transversal vertical par rapport à une onde à ultrasons d'excitation et qui se propage peut être déterminé en termes de techniques de mesure, **caractérisé par le fait que** le support (2, 3) pour la fixation du transducteur à ultrasons sur une tête d'assemblage d'une machine d'assemblage comprend une membrane (2) s'étendant verticalement à l'axe longitudinal du transducteur à ultrasons et au moins un détecteur (4, 6) est disposé sur/dans la membrane (2).

2. Transducteur à ultrasons selon la revendication 1, **caractérisé par le fait que** la membrane (2) présente la forme d'une membrane de type annulaire (2).

3. Transducteur à ultrasons selon l'une des revendications précédentes, **caractérisé par le fait qu'**au moins un détecteur (4, 6) est disposé au moins sur un côté de la membrane (2).

4. Transducteur à ultrasons selon l'une des revendications précédentes, **caractérisé par le fait qu'**un détecteur (4, 6) est collé et/ou vissé sur une membrane (2), en particulier sous la forme d'un élément (5) en forme de languette en saillie par rapport à la membrane.

5. Transducteur à ultrasons selon l'une des revendications précédentes, **caractérisé par le fait qu'**un détecteur (4, 6) a la forme d'un détecteur piézoélectrique.

6. Transducteur à ultrasons selon la revendication 5, **caractérisé par le fait qu'**un détecteur (4, 6) comprend au moins un élément piézoélectrique (6), en particulier qui entoure de manière annulaire l'axe longitudinal du transducteur à ultrasons.

7. Transducteur à ultrasons selon l'une des revendications précédentes, **caractérisé par le fait qu'**un élément piézoélectrique (6) présente au moins deux électrodes (4a, 4b, 4c, 4d), entre lesquelles une différence de potentiel peut être mesurée, les électrodes étant en particulier disposées de manière coaxiale entre elles.

8. Transducteur à ultrasons selon l'une des revendications précédentes, **caractérisé par le fait qu'**au moins une grandeur de mesure dépendante de l'allongement transversal (U₈) peut être détectée par la mesure d'une différence de potentiel
- entre les électrodes (4a, 4b, 4c, 4d) de deux éléments piézoélectriques (6) ou
- entre deux électrodes (4a, 4b, 4c, 4d) disposées espacées sur un élément piézoélectrique (6) ou entre plusieurs électrodes disposées espacées contre une électrode commune, en particulier une masse, la membrane formant en particulier elle-même une électrode.

9. Transducteur à ultrasons selon l'une des revendications précédentes, **caractérisé par le fait qu'**au moins un élément (5) en forme de languette est/peut être fixé sur la membrane (2), qui supporte au moins par secteurs un élément piézoélectrique (6), en particulier avec une électrode (4).

10. Transducteur à ultrasons selon l'une ou plusieurs des revendications précédentes, **caractérisé par le fait que** la membrane (2) présente une faible épaisseur par rapport à la propagation radiale.

11. Transducteur à ultrasons selon l'une ou plusieurs des revendications précédentes, **caractérisé par le fait que** le support (2, 3) pour la fixation du transducteur à ultrasons sur une tête d'assemblage d'une machine d'assemblage est disposé au point nodal de l'onde à ultrasons longitudinale excitée et qui se propage.

12. Transducteur à ultrasons selon l'une ou plusieurs des revendications précédentes, **caractérisé par le fait qu'**une électrode est formée par la membrane (2) elle-même.

13. Transducteur à ultrasons selon l'une ou plusieurs des revendications précédentes, **caractérisé par le fait que** la fine membrane (2) se prolonge par un anneau de montage (3) passant verticalement à la membrane (2) s'étendant de manière coaxiale autour du cône (1) du transducteur à ultrasons.

14. Procédé de détection par une technique de mesure d'au moins une grandeur de mesure, qui permet de déduire un paramètre de processus ou des grandeurs de processus en cas d'utilisation d'ultrasons, en mettant en oeuvre un transducteur à ultrasons selon l'une ou plusieurs des revendications précédentes, en particulier en détectant une grandeur de mesure représentant un allongement transversal, des paramètres de processus étant évalués pendant l'opération d'assemblage pour apprécier la qualité du processus d'assemblage et/ou étant utilisés en tant que grandeur de régulation, en particulier pour le réajustage de la force d'assemblage, de la puissance ou de la fréquence des ultrasons.

15. Procédé selon la revendication 14, **caractérisé par le fait que** la puissance des ultrasons actuellement transmise par le transducteur, ou des forces agissant dans ou sur la pointe de l'outil à ultrasons, en particulier des forces d'assemblage, sont déduites à l'aide de l'au moins une grandeur de mesure.
